# EUROPEAN PATENT SPECIFICATION

(11) **EP 4 018 125 B1**
(45) Date of publication and mention of the grant of the patent: **29.11.2023**
(21) Application number: 20772416.2
(22) Date of filing: 12.08.2020
(51) Int. Cl.: F23D 14/22, B60H 1/22, F24H 1/10, F23N 3/04, F23N 5/12, F23J 15/06, F23N 3/08, F23N 3/02, F23N 3/00, B60H 1/00, F24H 1/00, F24H 1/20, F24H 1/52

(54) **THERMOELECTRIC GENERATOR**
THERMOELEKTRISCHER GENERATOR
GÉNÉRATEUR THERMOÉLECTRIQUE

(30) Priority: 23.08.2019 IT 201900014991
(43) Date of publication of application: 29.06.2022
(73) Proprietor: GB Plast Srl, 40048 San Benedetto Val di Sambro (BO) (IT); MA-VE International Srl, 47892 San Marino (SM)
(72) Inventor: TONELLI, Alessandro, 40041 Gaggio Montano (BO) (IT)
(74) Representative: Busca, Andrea
(86) International application number: PCT/IB2020/057592
(87) International publication number: WO 2021/038354

(56) References cited:
- EP-A1- 2 745 334
- EP-A1- 2 911 210
- US-A- 5 450 869

## Description

The present invention relates to a thermoelectric generator. The invention has been made with particular reference to a combustion thermoelectric generator suitable for equipping a vehicle, especially a motorhome, a caravan or a watercraft. However, other applications, such as portable generators in general, are not excluded. It is also particularly suitable for small applications, such as the generation of heat for domestic use, for mountain huts, and in general for any place without direct connection to the public gas network.

### STATE OF THE ART

Combustion electric energy generators are known in the sector, particularly appreciated in the motorhome sector, where the vehicle must be energetically autonomous for all the needs of the occupants.

From the earlier Italian utility model no.BO2011U000093 by Longhi Giuliano a cogenerator for vehicles and rooms without electrical connection is known. Longhi's cogenerator comprises a burner and a circuit placed around the external wall of the combustion chamber thereof crossed by a fluid to be heated. Thermoelectric generators intended for the generation of electric energy, such as the Peltier cells which provide the well-known seebeck effect, are interposed between the combustion chamber and the path.

Longhi's cogenerator is very ingenious as in a small space and in a simple way it allows the recovery of the heat of the burner for heating air and water for domestic use, and the generation of current due to the seebeck effect.

However, Longhi's cogenerator leaves room for interesting improvements.

The subsequent patent application EP2911210 by Barin Luca exploits the principles of the Longhi's cogenerator described above, but does not improve it, as it refers to a generic management of the thermal delta for the generation of heat and the dissipation thereof, already anticipated by Longhi, which is able to manage automatic switching on and off as the temperature changes.

The documents US 5 450 869 A and EP 2 745 334 A1 both show a thermoelectric generator having the features specified in the preamble of claim 1.

The object of the present invention is to overcome the known generators indicated above by improving them.

A preferable object of the present invention is to optimize the heating of a vehicle obtained by means of a cogenerator which comprises a thermoelectric generator.

A preferable object of the present invention is to optimize the efficiency of a combustion thermoelectric generator placed on board a vehicle, especially a motorhome, or mobile in general.

A preferable object of the present invention is to optimize the efficiency of a seebeck effect thermoelectric generator.

A further preferred object of the present invention is to provide a thermoelectric generator which is easy and economical to manufacture.

### GENERAL INTRODUCTION

The present invention relates to a thermoelectric generator according to claim 1.

Preferably, said external side is substantially planar and said seebeck effect cells have a corresponding planar wall in contact therewith, where the seebeck cells are placed side by side with each other with a mosaic tile pattern so as to cover uniformly at least partially said external side.

Preferably, the means for generating seebeck effect electric energy (55, 70) uniformly cover both said upwardly converging walls (25a and 25b).

The means for generating seebeck effect electric energy (55, 70) are in an amount such as to produce at least sufficient electric energy to guarantee the autonomous operation of the thermoelectric generator and more generally of the cogenerator (1), for example by supplying a control unit. However, it is preferable that the amount of electric energy produced is greater to supply other utilises, as well.

According to a preferable general characteristic, the walls of the combustion chamber (25a and 25b) covered by the means for generating seebeck effect electric current (55, 70) are covered at least partially, preferably uniformly, by cooling means (30), where said seebeck generation means (55, 70) are operatively interposed between said walls (25a, 25b) and said cooling means (30).

In this case, the seebeck generation means preferably comprise a plurality of seebeck units cooled by the cooling means, fixed one independently of the other to said walls (25a, 25b) to cover them with a mosaic pattern.

According to a preferable general characteristic of the invention, the shielding and uniform heat radiation means (45) comprise a flange with a V-shaped section, interposed between the flame generation means and said upwardly converging sides of the combustion chamber, oriented with the cusp (46) like the cusp (38) formed by said sides (25a, 25b).

The flange (45) preferably extends substantially over the entire length L of the chamber (25) in a direction orthogonal to the triangular section, where preferably also the flame generation means (36) have the same length.

According to some preferred embodiments, the flange (45) comprises one or more openings (48) on both sides of the v arranged in the zones with lower heat, for example in a position proximal to the cusp (46), to allow a greater passage of heat from the flame to the upper parts of the walls (25a and 25b) of the combustion chamber.

According to some preferred embodiments of the invention, said seebeck cells are each part of respective cooled seebeck units, for example comprising support means for at least one cooling duct.

Preferably each unit comprises a compression plate (58) for clamping a seebeck cell (55) on a relative wall (25a, 25b) of the combustion chamber (25), where said plate defines at least partial support means (62) of a cooling circuit (30) on a side (58b) opposite to a side (58a) of contact with the seebeck cell (55).

According to a further preferable feature each unit comprises a second plate (60) coupled to the compression plate (58) to define between them a housing and support seat (62) of a duct (65) of the cooling circuit (30).

According to some preferred embodiments, said housing and support seat (62) has a surface of contact with said duct extended in the longitudinal direction of the duct as much as the extension (L1) of the compression plate (58) in that direction, where this direction is preferably parallel to the respective covered side (25a, 25b) of the combustion chamber (25).

Preferably, the invention relates to a thermal generator comprising a combustion chamber (25) supplied separately with air and fuel gas in such a way as to be introduced in a form not premixed between them and in a variable ratio, in particular the chamber is supplied by respective air supply means and by fuel gas supply means, where:
- the generator comprises means for forced suction of the flue gases (72);
- the air supply means (80) comprise a suction opening of variable dimensions by means of a throttle valve (82).

According to some preferred embodiments, the throttle valve (82) can be controlled or moved manually, based on the indications given by a processing unit (78) communicating with at least one probe for detecting at least one parameter of the flue gases (74) of the combustion chamber and at least with means for detecting the height above sea level (76) and/or with means for detecting the atmospheric pressure.

Preferably the processing unit (78) is programmed according to optimal operating windows, each identified by a combination of ranges of parameter values selected from a parameter of the flue gases, a parameter of the flame in the combustion chamber, the height above sea level, the atmospheric pressure, a current value, in particular the processing unit is programmed to associate a respective predetermined position of the intake air throttle valve to each optimal operating window.

According to some preferred embodiments, the throttle valve (82) can be controlled or set manually, based on the indications given by a processing unit (78) communicating with at least one probe for detecting the flame presence in the combustion chamber (25).

In this case, for example, the flame presence probe is an ionization probe which exploits the presence of positive ions developed by the combustion of hydrogen and oxygen to generate an electric current,
the processing unit being programmed to determine whether the flame of the combustion chamber is ignited or not based on the measurement of said current and to make an estimate of the production of C02 based thereon, the processing unit is also programmed to adjust the parameters of the suction speed (72) and/or of the amount of air introduced into the chamber based on said CO2 estimate.

Preferably the flame presence probe is composed of two electrodes crossed by the flame, one positive and one negative, the ions produced by the heat of the flame are attracted to the negative electrode rich in electrons and give rise to a weak direct current measured by the processing unit.

According to a general aspect thereof, the invention relates to a combustion control process in a generator, according to the invention, characterized by:
- supplying the combustion chamber with air and fuel gas not premixed between them;
- introducing into the combustion chamber, by suction for example resulting from a forced suction of the flue gases, the air not premixed with the gas and in a variable amount defined based on at least one of: a parameter of the flue gases, a parameter of the flame in the combustion chamber, the height above sea level, the atmospheric pressure, a current value.

Preferably, the flame parameter is a direct current determined by an ionization probe.

### DETAILED DESCRIPTION

Further characteristics and advantages of the present invention will become clearer from the following detailed description of preferred embodiments thereof, with reference to the appended drawings and provided by way of an indicative and non-limiting example. In such drawings:
- Figure 1 schematically represents a cogenerator comprising a generator according to the present invention;
- Figures 2 and 3 show the burner of the cogenerator of Figure 1;

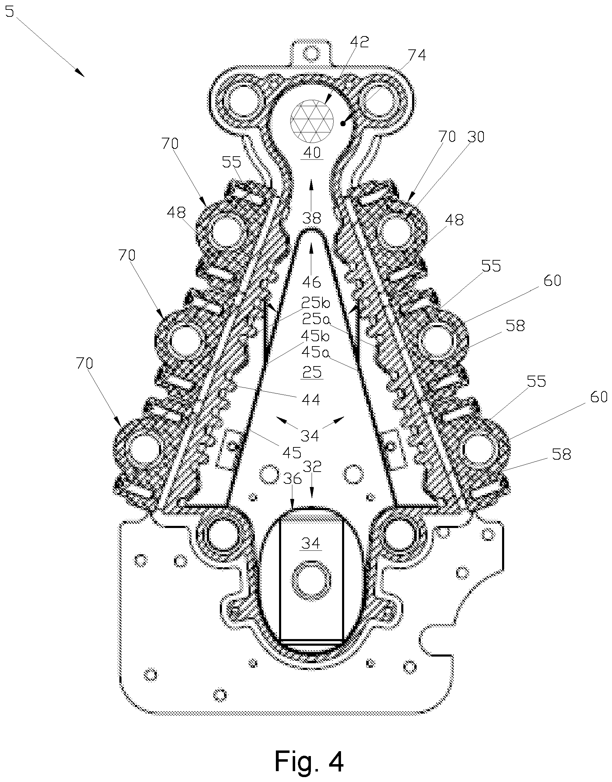

- Figure 4 represents a cross section of the combustion chamber of the burner of the previous figures:
- Figure 5 schematically represents the cogenerator of Figure 1 according to a different perspective point of view which highlights the outlet duct of the flue gases from the combustion chamber;

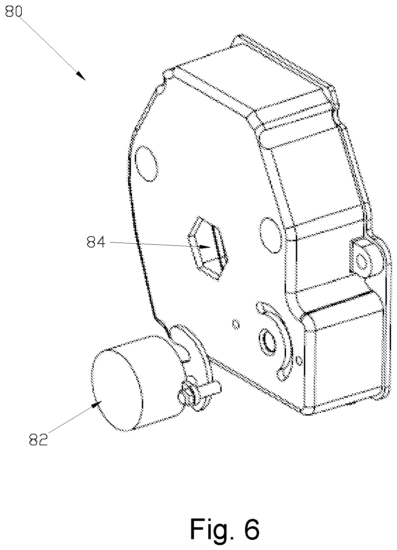

- Figure 6 shows an exploded view of the throttle means of the air entering the combustion chamber;
- Figure 7 shows an exploded view of the heat exchanger of the cogenerator of the previous figures;
- Figure 8 schematically shows a heating and hot water supply system for sanitary use comprising the cogenerator of the previous figures particularly suitable for a motorhome;
- Figure 9 schematically shows a motorhome equipped with the system of Figure 8.

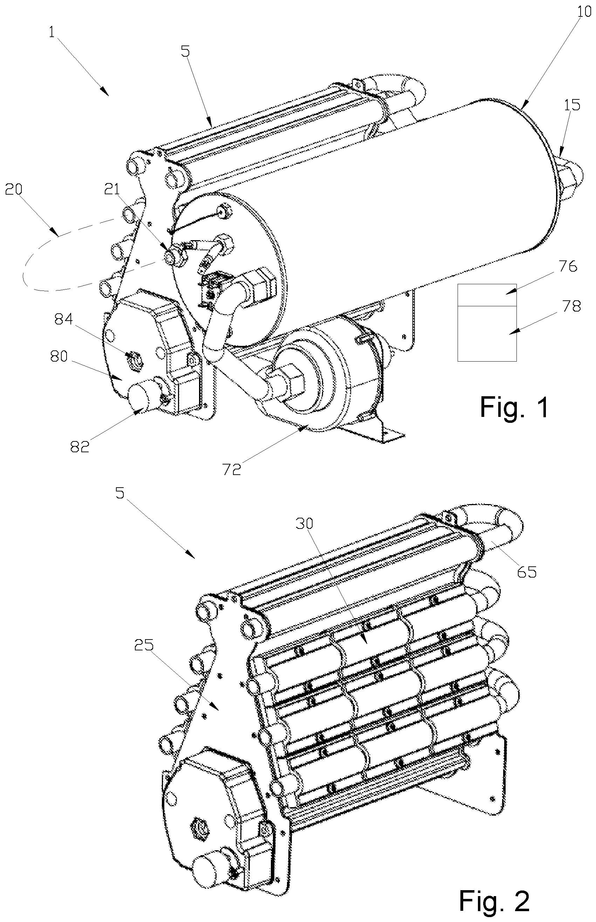

Figure 1 shows a cogenerator indicated as a whole with the reference number 1.

The cogenerator 1 is formed as a cogeneration unit comprising a thermoelectric generator 5, and a heat exchanger 10 operatively connected to each other.

In particular, the unit 1 comprises first means 15 for conveying the combustion gases of the thermoelectric generator 5 to the exchanger 10, and second means 20 for conveying the preheated fluid from the generator 5 to the exchanger 10.

The preheated fluid, as will be seen below, first acts as a cooling fluid of the generator, so as to acquire heat and then transfer it to the exchanger.

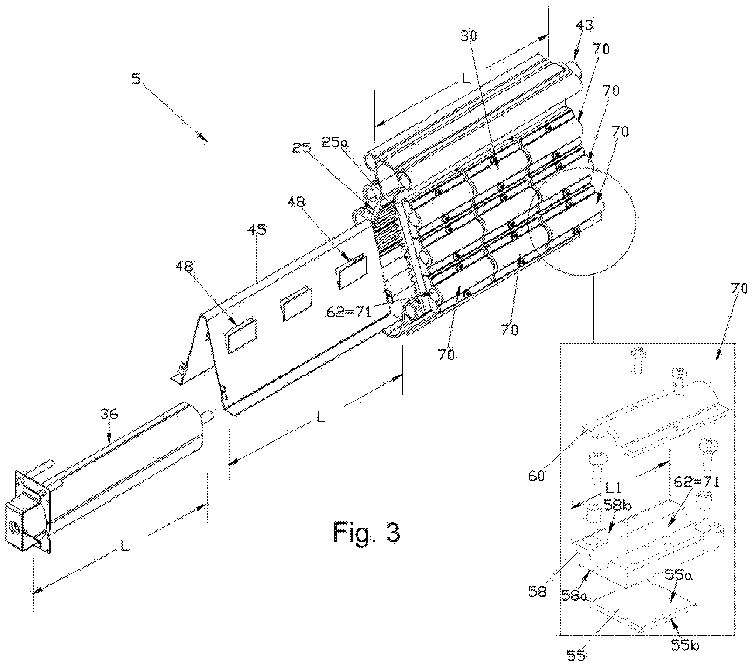

With reference to Figures 2 and 3, the generator 5 comprises a substantially prismatic combustion chamber 25 with a substantially triangular section.

The upwardly converging walls 25a and 25b of the triangular prism 25 are covered externally to the chamber by a cooling circuit 30 connected to the exchanger to send the preheated fluid by means of the first conveying means 15.

The cooling circuit 30 uniformly covers the prism on two external sides of the triangle.

The section of the chamber 25 is substantially like an isosceles triangle, where the base side 32 is preferably shorter than the other two 34 converging upwards and opens onto a lower internal seat 35 for housing burner means 36 suitable for introducing the fuel.

The cusp 38 of the triangular section opposed to the base 32 opens onto an upper internal channel 40 for collecting the flue gases, preferably comprising catalyst means 42. The channel 40 communicates with a suction outlet 43.

The walls 25a and 25b which define the upwardly converging sides 34 have corrugated internal sides to increase the heat absorption surface, for example they comprise lamellae 44 projected towards the inside of the chamber 25.

The chamber 25 comprises internally means for the uniform radiation of heat 45 to the walls 25a and 25b. In particular, said means 45 comprise an inverted V section flange 45 interposed between the burner means 36 and the upwardly converging walls 25a and 25b. In this way, the cusp 46 of the flange 45 is oriented like the cusp 38 of the chamber 25.

The flange 45 has walls 45a and 45b substantially parallel to the upwardly converging walls 25a and 25b of the chamber 25. It substantially extends over the entire length L of the chamber 25 in a direction orthogonal to the triangular section. It can be observed that the burner 36 preferably also has the same length.

The flange 45 has substantially solid walls, for example made of sheet metal, so as to shield the walls 25a and 25b from the flame. The walls of the flange 45 comprise one or more openings 48 on both sides of the v, in equal numbers and mirror each other. Said openings are arranged proximal to the cusp 46 and allow a greater passage of heat from the burner to the upper parts of the walls 25a and 25b, which otherwise would be colder than the lower parts, closest to the flame.

The openings 48 for example are made by bending flange edges cut into the walls 45a and 45b. Such edges, for example, are joined to the remaining part of the flange in a lower side and are distanced therefrom in the upper part. The openings 48 are preferably generally aligned with each other in the direction of the length L of the chamber 25, and preferably have a rectangular section. Preferably there is only one line of openings 48 for each wall 45a and 45b.

The upwardly converging walls 25a and 25b have respective flat external surfaces for coupling to a plurality of seebeck effect cells 55. Each cell 55 is fixed to the respective wall 25a/25b independently of the other cells 55, by means of a respective compression plate 58. Each seebeck effect cell 55 is interposed between the wall 25a/25b and the relative compression plate 58, where the latter are clamped between them, for example by means of screws. In this way it is advantageously possible to ensure that all the cells 55 have an optimal support to the wall of the combustion chamber, and therefore that their side intended to be "hot" for the seebeck effect to function, is suitably heated.

The cells 55 and the compression plates 58 are better visible in the enlarged and exploded scale detail of Figure 3. Here it can be noted how the seebeck effect cells 55 are cells with two flat sides 55a and 55b opposed to each other, one destined to be hotter than the other in order to generate the thermal delta between them optimal for the production of electric energy.

The compression plate 58 has a flat face 58a of contact with the relative cell 55, while the opposite face 58b is shaped with a concave section so as to form together with a second plate with concave section 60 a seat 62 for a cooling duct 65 at the back of the cell 55.

The seat 62 preferably has a surface of contact of the compression plate 58 with the cooling duct 65 extended over the whole length L1 of said plate 58, thus increasing the exchange surface.

Even more preferably, also the surface of contact of the second concave plate 60 with the cooling duct 65 extends over the entire length L1, thus increasing the exchange surface.

In general, it is preferable that the plates 58 and 60 form a seat 62 between them which is a containment and contact duct 71 for the cooling duct 65, preferably with a circular section having a diameter equal to the external diameter of the duct 65 and a length equal to at least one of the two plates 58, 60, preferably at least 58, so as to maximize the mutual contact surfaces.

The seats 62 are arranged aligned with each other to form a plurality of parallel ducts 71 on the walls 25a/25b, preferably uniformly distributed so as to make the external temperature uniform.

In general it is preferable that the respective area of the opposed faces 55a and 55b of the seebeck cell 55 is smaller than the area of the face 58a of the compression plate 58, in particular it is preferable that the latter completely overlaps the seebeck cell.

In particular, the seats 62 act as a support for the duct 65 of the cooling circuit 30, which in this way takes the heat from the walls of the cells 55 and gives it to the exchanger 10.

The duct 65 preferably follows a path from an inlet to an outlet of the cooling circuit 30, from which it continues towards the exchanger 10. Along this path the duct 65 first meets the cells 55 located in the lower part of the generator and potentially hotter, and then those in the upper part.

The cooling fluid leaving the cooling circuit 30 is a preheated fluid carried to the exchanger 10 by the second conveying means 20.

In general, the fluid flowing in the cooling circuit 30 comprises glycol, more preferably a mixture comprising at least water and glycol.

Each cell 55 and the relative plates 58 and 60 form respective cooled seebeck units 70 which cover the outside of the walls 25a and 25b of the combustion chamber like a uniform mosaic, the example shows 9 on each side.

At least the plate 58 is made of a material with high thermal conductivity, for example aluminium.

The walls 25a and 25b of the combustion chamber are made of a material with high thermal conductivity and resistance to high temperatures, for example the 6060 Anticorodal aluminum-magnesium-silicon alloy.

In general, it can be observed that a seebeck cell can preferably be made with many Peltier effect junctions in series.

The electric energy produced by the seebeck cells 55 is preferably stored in a battery 160 for supplying the control unit 170 and in general all the electrical parts of the cogenerator 1, which can be, for example, one or more spark plugs of the burner, and one or more temperature sensors.

In use, the burner 36 generates a flame in the chamber 25. The heat meets the V-shaped flange 45 which transmits the heat substantially uniformly to the walls 25a and 25b of the chamber 25. In this way the internal faces 55b of the seebeck effect cells 55 are optimally heated, being all substantially at the same temperature, preferably around 200° C. Furthermore, each of them enjoys uniform heating thanks to the fact that it adheres optimally to the respective hot wall 25a or 25b of the combustion chamber 25 thanks to the clamping exerted by the respective compression plate 58 independent of the other plates 58 of the other cells, like the mosaic tiles.

The external faces of the seebeck cells 55 are optimally cooled by the cooling duct 65 thanks to the fact that the duct takes heat from the compression plate 58 over the entire length thereof.

In this way it is possible to keep the external faces 55a of the seebeck cells, for example substantially around 80°C, providing a thermal delta optimal for the production of electric energy.

It is believed that the aspect of the mosaic distribution of the cooled seebeck units 70 and the aspect of the means for the uniform heat radiation 45 can also be exploited independently of each other in a thermoelectric generator, in this case for example, the mosaic distribution could also be adopted with combustion chambers of a different shape from the one illustrated.

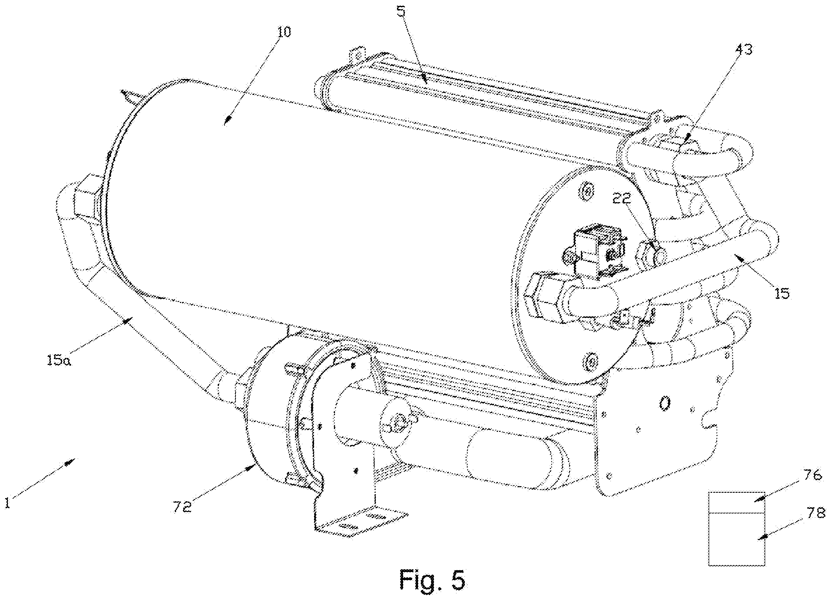

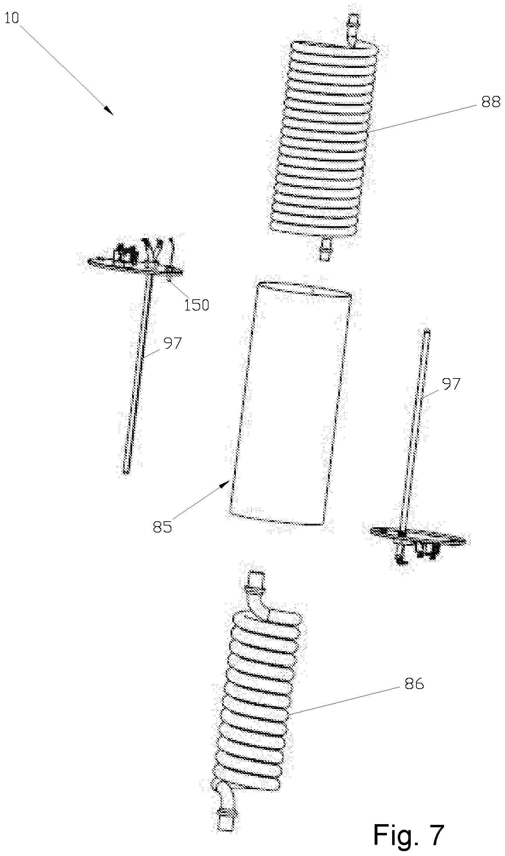

With reference to the rear view of Figure 5, the connection between the suction outlet 43 and the first means 15 for conveying the combustion gases of the thermoelectric generator 5 to the exchanger 10 is better visible. The conveying means pass through the exchanger 10, for example in the form of a thermal exchange coil 86 (Figure 7) to exchange heat with other fluids, and continue in a section 15b for conveying to forced suction means 72, which can be made for example with a rotary pump or a fan.

The thermoelectric generator 5 comprises air supply means 80 and gaseous fuel supply means 84 not mixed with air.

The gaseous fuel supply means comprise, for example, a duct and a solenoid valve for enabling the passage from a storage cylinder to the combustion chamber 25.

The air is sucked into the chamber 25 in an induced manner by the means for sucking the flue gases. There are no means for forced air injection into the chamber.

The air supply means 80 comprise an opening for access of the air to the combustion chamber with variable dimensions by means of a throttle valve 82.

The thermoelectric generator 5 further comprises a flue gas analysis probe 74 and means for determining the height above sea level 76 fixed to the cogenerator 1. They communicate the detected parameters to a processing unit 78 programmed according to optimal operation windows, each identified by a combination of ranges of values of at least one parameter of the flue gases and the height above sea level. The processing unit is programmed to associate a respective predetermined position of the intake air throttle valve to each optimal operating window.

The processing unit is programmed to control the positioning of the valve 82, or to signal the positioning to be selected manually.

The combustion chamber 25, therefore, receives gaseous fuel and air not previously mixed between them, and in a ratio varied by the action of the throttle valve 82, based on the values of altitude above sea level and of at least one combustion parameter.

This aspect allows realising particularly small combustion chambers compared to those required with a supply of premixed air and fuel or with forced air injection. It also allows optimal operation when the motorhome moves with the generator on board.

Furthermore, the presence of the suction system permits to make the generator safe against any gas leaks, which would be sucked in and conveyed to the exhaust.

Finally, the generator is advantageously adaptable to various types of gas, in particular to both LPG and methane, by programming the processing unit 78 with a mapping of combustion values of the selected gas to be compared with those detected by the probe 74, and by installing suitable delivery nozzles.

In addition or as an alternative to the management of the combustion by controlling the air suction based on the analysis of the exhaust gases with the relative probe 74, we have verified that also a management through analysis of the flame in the combustion chamber provides useful results.

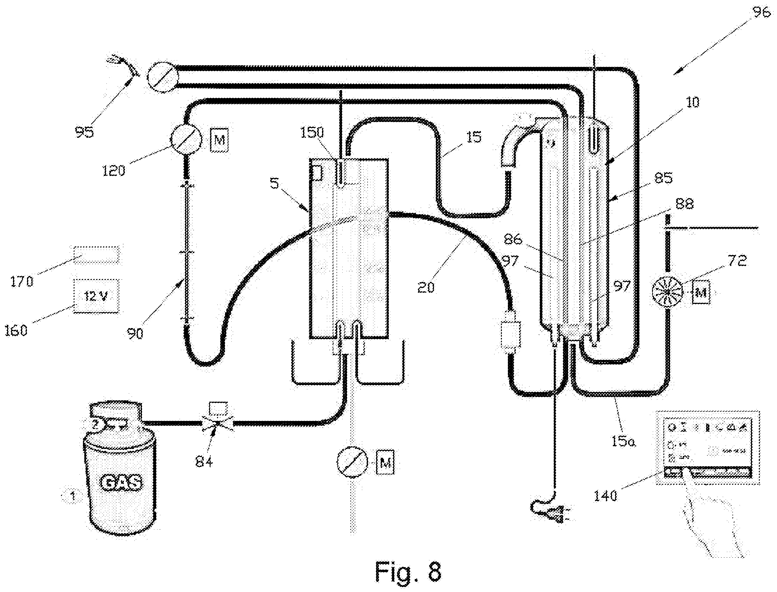

For example, it is possible to use a flame presence detection probe 190 in the combustion chamber 25 (Figure 8). This probe is, for example, an analysis probe capable of returning at least one parameter linked to the characteristics of the flame.

For example, the probe 190 is an ionization probe which exploits the presence of positive ions developed by the combustion of hydrogen and oxygen.

The probe is generally composed of two electrodes crossed by the flame, one positive and one negative, the ions produced by the heat of the flame are attracted to the negative electrode rich in electrons and give rise to a weak direct current. The current is a characteristic parameter of the flame that can be used to derive an air suction control.

By measuring this current it is possible to determine whether the flame is ignited or not and there is also a first effective indication for the excessive generation of CO2 (carbon dioxide) to be used immediately for the adjustment of the parameters of the suction speed (72) and/or of the amount of air introduced into the chamber (82).

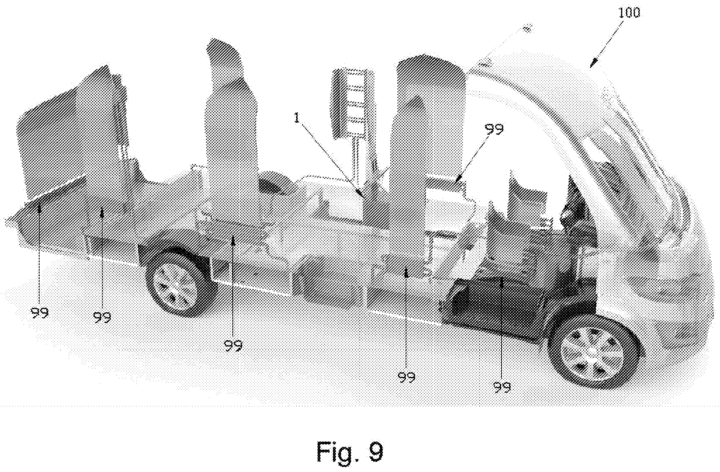

With reference now to Figures 7 and 8, the exchanger 10 comprises a tank 85 full of fluid, in communication with the cooling circuit 30 and with a room heating circuit of a vehicle 90 (Figure 9) suitable for heating the living spaces. Said communications take place respectively through the openings 21 (Figure 1) and 22 (Figure 5). The heating circuit comprises, for example, radiators or convectors 99 (Figure 9).

The fluid in the tank 85 is the fluid preheated by the circulation in the cooling circuit 30 and subsequently brought to the exchanger 10 by the second conveying means 20. The tank 85 is preferably cylindrical in shape. As mentioned, the fluid is preferably a mixture of water and glycol.

The tank 85 contains a first coil 86 and a second coil 88 immersed in the preheated fluid. Said coils cross the tank from respective inlet points to respective outlet points, and preferably have development axes of the spiral that are parallel, preferably coinciding, with the development axis of the cylinder of the tank 85.

In general, the two coils 86 and 88 are preferably arranged with a development of the spiral according to respective coaxial axes, and one of the two develops with a diameter of the windings smaller than the diameter of the windings of the other one, so that the windings of one are placed externally to the windings of the other one.

The first coil 86 is crossed by exhaust gases coming from the combustion chamber 25. As these gases are hotter than the preheated fluid, the latter further increases its temperature. The coil 86 is preferably operatively interposed between the combustion chamber 25 and the suction fan of the exhaust gases 72.

The second coil 88 is crossed by water, a coil for instantaneous heating of water for sanitary use sent to a respective delivery circuit 95.

In this way the cogenerator 1, the room heating circuit 90 and the sanitary water delivery circuit 95 define a service system 96 for the electric, heating and sanitary water utilities for the vehicle, for example the motorhome 100 in Figure 9.

Optionally, one or more electric resistors 97 are immersed inside the tank 85 for heating the fluid in the event that the thermoelectric generator 5 is not in operation. The resistors 97 can therefore be electrically connected to an electrical network, by means of a current socket.

In general, the cogenerator 1 and the service system 96 fulfil the dream of any motorhome owner, namely:
- No frost problems in the hot water storage tank, as sanitary hot water is, among other things, instantaneously generated.
- No need to drain water below 0°C
- No electricity consumption, but rather the possibility of producing electricity in amounts greater than consumption.

Below we describe a preferred operating principle and some preferable options for completing the service system 96. The cogenerator control unit is preferably programmed to perform the following functions.

When starting the cogenerator 1, it is preferable to carry out a preliminary washing step before ignition in which the combustion chamber 25 is ventilated to ensure that no gas residues are present; for this operation the same suction fan 72 is normally used which will then draw the air necessary for combustion.

Finally, it is proceeded with the ignition:
an electromagnetic valve 84 opens the duct for supplying the gas to the combustion chamber 25, where it is ignited by means of a spark plug positioned on the burner 36. A sensor checks that the flame has ignited: if this does not happen, the gas inflow is immediately interrupted. Once ignited, the flame develops inside the combustion chamber 25 bringing the fluid contained in the tank 85 of the exchanger 10 to the predetermined temperature (for example a maximum temperature of 85°C). The temperature in the tank 85 is generally controlled by sensors 150 (for example one or more bipolar thermostats) connected to the control unit of the cogenerator. Said fluid is also called heating liquid directed to the convectors, or cooling liquid of the seebeck cells. The exhaust fumes are sucked from the outside of the exchanger through the fan 72 while new fresh air reaches the burner through the throttle valve 82.

If the temperature of the heating liquid is lowered, the cogenerator ignites again automatically, supplying new heat to the convectors: in this way, the temperature of the heating liquid in the tank 85 is kept constant, minimizing heat variations.

Thanks to this, even the water intended for sanitary use 95 is always kept hot.

If a connection to the electrical network is available, the cogenerator can be supplied with electricity thanks to the presence of the resistors 97, positioned inside the tank 85. Preferably it is possible to select the power delivered by the resistors between 1, 2 or 3 kW depending on the amount of current available. In addition, the gas/electric heating modes can also be selected simultaneously, making the most of the caloric power of the cogenerator and using the electric resistors in order to reduce gas consumption: in this way, in fact, priority is given to electric heating with gas heating ready to intervene in case of need.

By way of purely indicative example, a sizing suitable for motorhomes is possible according to which if operated with propane gas, the cogenerator is able to deliver a maximum power of 5.5 kW, and 6.4 kW if operated with butane). For example, 3 kW made available with electrical operation can be added to this data, which raise the maximum output to 8.5 kW (9.4 kW if operated with butane).

The heating liquid is distributed by means of a recirculation pump, powered at 12v, or by a second pump at 230v: if fitted, this is automatically preferred by the system (always and only in case of connection to the electric network). The heating liquid is then circulated through a network of convectors 99 and unit heaters capable of delivering, for example, a calorific power of 400W/m.

The circulation pump is controlled by a thermostatic probe which measures the temperature of the room to be heated: this, in turn, works according to what is set via a special control panel. Consequently, when the temperature detected by the probe falls below the desired value, the pump and the cogenerator are reactivated, heating the liquid again and making it circulate again inside the system until the desired temperature is reached.

A system of this type could in the long run generate air pockets inside the system: to prevent this from happening, the heater is equipped with an automatic bleeding: there are also numerous vent valves in the key points of the system to allow a quick elimination.

The diffusion of heat occurs by convection: the convectors 99, positioned laterally along the walls of the room to be heated, for example the motorhome, behind the furniture specially provided with ventilation, and, more and more often, on the floor, release heat by heating the air: once it is heated, it tends to rise along the walls pushing, in the middle of the vehicle and downwards, the cooler air. Upon meeting the unit heaters, it heats up again by repeating this cycle indefinitely.

The convectors exploit a mixture preferably comprising a mixture in approximately the following proportions: water (60%) and glycol (40%).

The heater can be started according to a summer mode for heating sanitary hot water only by means of a special selector 120.

Other accessories and additional components:
The heater is combined with an LCD touch screen 140 control panel which is equipped with an electronic thermostat and provides numerous indications both on operation and on any maintenance, as well as, obviously, allowing complete programming of the system.

## Claims

1. A thermoelectric generator comprising a combustion chamber (25) which houses internally shielding and radiation means (45) to shield at least one wall of the combustion chamber from the direct heat coming from the combustion flame, on the external side of the at least one wall a plurality of generating means for generating seebeck effect electric energy (55, 70) are fixed, and to radiate the at least one wall with a substantially uniformly distributed heat, where said plurality of generation means comprises a plurality of seebeck effect cells fixed to said wall, one independently of the other, and arranged so as to cover the at least one wall at least partially with a mosaic tile pattern;
the thermoelectric generator being **characterised by** said combustion chamber being a substantially prismatic combustion chamber (25) with a substantially triangular section:
• the prismatic combustion chamber comprises two upwardly converging walls (25a and 25b), at least one covered externally to the combustion chamber by means for generating seebeck effect electric energy (55, 70);
• the combustion chamber houses internally flame generation means (36) in proximity or at the lower side of the prism;
• the combustion chamber houses internally shielding and radiation means (45) to shield said upwardly converging walls (25a, 25b) from the direct heat coming from said flame and to radiate them with a substantially uniformly distributed heat.

2. The thermoelectric generator according to claim 1, **characterized in that** said external side is substantially planar and said seebeck effect cells have a corresponding planar wall of contact therewith, where the seebeck effect cells are placed side by side with each other with a mosaic tile pattern so as to cover uniformly at least partially said external side, more preferably both said upwardly converging walls (25a and 25b).

3. The thermoelectric generator according to claim 1 or 2, **characterized in that** the shielding and radiation means (45) comprise a flange with a V-shaped section, interposed between the flame generation means and said upwardly converging walls of the combustion chamber, oriented with the cusp (46) like the cusp (38) formed by said upwardly converging walls (25a, 25b).

4. The thermoelectric generator according to the preceding claim, **characterized in that** the flange (45) extends substantially over the entire length L of the combustion chamber (25) in a direction orthogonal to the triangular section, where preferably also the flame generation means (36) have the same length.

5. The thermoelectric generator according to claim 3 or 4, **characterized in that** the flange (45) comprises one or more openings (48) on both sides of the flange with a V-shaped section arranged in the zones with lower heat, in particular in a position proximal to the cusp (46), to allow a greater passage of heat from the flame to the upper parts of the upwardly converging walls (25a and 25b) of the combustion chamber.

6. A thermoelectric generator according to any one of the preceding claims wherein the combustion chamber (25) is supplied separately with air and fuel gas in such a way as to be introduced in a form not premixed between them and in a variable ratio, in particular the combustion chamber is supplied by respective air supply means (82) and by fuel gas supply means (84), where:
• the generator comprises means (72) for forced suction of the flue gases;
• the air supply means (82) comprise a suction opening of variable dimensions by means of a throttle valve (82).

7. The thermoelectric generator according to the preceding claim, **characterized in that** the throttle valve (82) is controlled or set manually, based on the indications given by a processing unit (78) communicating with at least one probe for detecting at least one parameter of the flue gases (74) of the combustion chamber and at least with means for detecting the height above sea level (76) and/or with means for detecting the atmospheric pressure.

8. The thermoelectric generator according to the preceding claim, **characterized in that** the processing unit (78) is programmed according to optimal operating windows, each identified by a combination of ranges of parameter values selected from a parameter of the flue gases, a parameter of the flame in the combustion chamber, the height above sea level, the atmospheric pressure, a value of current, in particular the processing unit is programmed to associate a respective predetermined position of the intake air throttle valve to each optimal operating window.

9. The thermoelectric generator according to any one of claims 6 to 8, **characterized in that** the throttle valve (82) is controlled or set manually, based on the indications given by a processing unit (78) communicating with at least one probe for detecting the flame presence in the combustion chamber (25).

10. The thermoelectric generator according to the preceding claim, **characterized in that** the flame presence probe is an ionization probe which exploits the presence of positive ions developed by the combustion of hydrogen and oxygen to generate an electric current,
the processing unit being programmed to determine whether the flame of the combustion chamber is ignited or not based on the measurement of said current and to make an estimate of the production of C02 based thereon, the processing unit is also programmed to adjust the parameters of the suction speed and/or of the amount of air introduced into the combustion chamber based on said CO2 estimate.

11. The thermoelectric generator according to claim 9 or 10, **characterized in that** the flame presence probe is composed of two electrodes crossed by the flame, one positive and one negative, the ions produced by the heat of the flame are attracted to the negative electrode rich in electrons and give rise to a weak direct current measured by the processing unit.

12. The thermoelectric generator according to any one of the preceding claims **characterized in that** said seebeck effect cells are each part of a respective cooled seebeck unit, wherein each cooled seebeck unit comprises a compression plate (58) for clamping a seebeck cell (55) on a relative upwardly converging wall (25a, 25b) of the combustion chamber (25), where said plate defines at least a partial support seat (62) of a cooling circuit (30) on one side (58b) opposite to another side (58a) of contact with the seebeck cell (55) .

13. The thermoelectric generator according to the preceding claim, **characterized in that** each unit cooled seebeck unit comprises a second plate (60) coupled to the compression plate (58) to define between them a housing and support seat (62) of a duct (65) of the cooling circuit (30).

14. A process for controlling the combustion in a generator according to any one of the preceding claims, comprising:
- supplying the combustion chamber with air and fuel gas not premixed between them;
- introducing into the combustion chamber, by suction, the air not premixed with the gas and in a variable amount defined based on at least one of: a parameter of the flue gases, a parameter of the flame in the combustion chamber, the height above sea level, the atmospheric pressure, a value of current.

15. The process according to claim 14, wherein the flame parameter is a direct current determined by means of an ionization probe.

## Patentansprüche

1. Thermoelektrischer Generator, der eine Brennkammer (25) umfasst, die innen Abschirm- und Strahlungsmittel (45) aufnimmt, um mindestens eine Wand der Brennkammer von der direkten Wärme abzuschirmen, die von der Verbrennungsflamme kommt, wobei auf der Außenseite der mindestens einen Wand eine Vielzahl von Erzeugungsmitteln zur Erzeugung von elektrischer Seebeck-Effekt-Energie (55, 70) befestigt sind, und die mindestens eine Wand mit einer im Wesentlichen gleichmäßig verteilten Wärme zu bestrahlen, wobei die mehreren Erzeugungsmittel eine Vielzahl von Seebeck-Effekt-Zellen umfassen, die unabhängig voneinander an der Wand befestigt sind, und so angeordnet sind, dass sie die mindestens eine Wand mindestens teilweise mit einem Mosaikfliesenmuster bedecken;
wobei der thermoelektrische Generator **dadurch gekennzeichnet ist, dass** die Brennkammer eine im Wesentlichen prismatische Brennkammer (25) mit einem im Wesentlichen dreieckigen Querschnitt ist:
- die prismatische Brennkammer zwei nach oben konvergierende Wände (25a und 25b) aufweist, von denen mindestens eine außerhalb der Brennkammer durch Mittel zur Erzeugung elektrischer Seebeck-Effekt-Energie (55, 70) abgedeckt ist;
- sich im Innern der Brennkammer in der Nähe oder an der Unterseite des Prismas Mittel zur Flammenerzeugung (36) befinden;
- sich im Innern der Brennkammer Abschirm- und Strahlungsmittel (45) befinden, um die nach oben konvergierenden Wände (25a, 25b) von der direkt von der Flamme kommenden Wärme abzuschirmen und sie mit einer im Wesentlichen gleichmäßig verteilten Wärme zu bestrahlen.

2. Thermoelektrischer Generator nach Anspruch 1, **dadurch gekennzeichnet, dass** die Außenseite im Wesentlichen eben ist und die Seebeck-Effekt-Zellen eine entsprechende ebene Kontaktwand aufweisen, wobei die Seebeck-Effekt-Zellen in einem Mosaikfliesenmuster nebeneinander angeordnet sind, so dass sie die Außenseite mindestens teilweise, besonders bevorzugt beide nach oben konvergierenden Wände (25a und 25b) gleichmäßig bedecken.

3. Thermoelektrischer Generator nach Anspruch 1 oder 2, **dadurch gekennzeichnet, dass** die Abschirm- und Strahlungsmittel (45) einen Flansch mit V-förmigem Querschnitt umfassen, der zwischen den Flammenerzeugungsmitteln und den nach oben konvergierenden Wänden der Brennkammer angeordnet ist und mit dem Scheitelpunkt (46) wie dem durch die nach oben konvergierenden Wände (25a, 25b) gebildeten Scheitelpunkt (38) ausgerichtet ist.

4. Thermoelektrischer Generator nach dem vorstehenden Anspruch, **dadurch gekennzeichnet, dass** sich der Flansch (45) im Wesentlichen über die gesamte Länge L der Brennkammer (25) in einer Richtung orthogonal zum dreieckigen Querschnitt erstreckt, wobei vorzugsweise auch die Flammenerzeugungsmittel (36) die gleiche Länge aufweisen.

5. Thermoelektrischer Generator nach Anspruch 3 oder 4, **dadurch gekennzeichnet, dass** der Flansch (45) eine oder mehrere Öffnungen (48) auf beiden Seiten des Flansches mit einem V-förmigen Querschnitt aufweist, die in den Zonen mit geringerer Wärme, insbesondere in einer Position in der Nähe des Scheitelpunkts (46) angeordnet sind, um einen größeren Durchgang der Wärme von der Flamme zu den oberen Teilen der nach oben konvergierenden Wände (25a und 25b) der Brennkammer zu ermöglichen.

6. Thermoelektrischer Generator nach einem der vorstehenden Ansprüche, wobei die Brennkammer (25) getrennt mit Luft und Brenngas derart versorgt wird, dass diese in nicht vorgemischter Form und in einem variablen Verhältnis zueinander eingebracht werden, insbesondere wird die Brennkammer durch entsprechende Luftzufuhrmittel (82) und Brenngaszufuhrmittel (84) versorgt, wobei:
- der Generator Mittel (72) zur Zwangsabsaugung der Abgase umfasst;
- die Luftzufuhrmittel (82) eine Ansaugöffnung mit variablen Abmessungen mittels eines Drosselventils (82) umfassen.

7. Thermoelektrischer Generator nach dem vorstehenden Anspruch, **dadurch gekennzeichnet, dass** das Drosselventil (82) manuell gesteuert oder eingestellt wird, und zwar auf der Grundlage der Angaben einer Verarbeitungseinheit (78), die mit mindestens einer Sonde zur Erfassung mindestens eines Parameters der Abgase (74) der Brennkammer und mindestens mit Mitteln zur Erfassung der Höhe über dem Meeresspiegel (76) und/oder mit Mitteln zur Erfassung des atmosphärischen Drucks in Verbindung steht.

8. Thermoelektrischer Generator nach dem vorstehenden Anspruch, **dadurch gekennzeichnet, dass** die Verarbeitungseinheit (78) gemäß optimalen Betriebsfenstern programmiert ist, die jeweils durch eine Kombination von Bereichen von Parameterwerten identifiziert werden, die aus einem Parameter der Abgase, einem Parameter der Flamme in der Brennkammer, der Höhe über dem Meeresspiegel, dem atmosphärischen Druck und einem Stromwert ausgewählt werden, wobei die Verarbeitungseinheit insbesondere so programmiert ist, dass sie jedem optimalen Betriebsfenster eine entsprechende vorbestimmte Position des Ansaugluftdrosselventils zuordnet.

9. Thermoelektrischer Generator nach einem der Ansprüche 6 bis 8, **dadurch gekennzeichnet, dass** das Drosselventil (82) manuell gesteuert oder eingestellt wird, und zwar auf der Grundlage der Angaben einer Verarbeitungseinheit (78), die mit mindestens einer Sonde zur Erfassung des Vorhandenseins einer Flamme in der Brennkammer (25) in Verbindung steht.

10. Thermoelektrischer Generator nach dem vorstehenden Anspruch, **dadurch gekennzeichnet, dass** die Sonde für das Vorhandensein einer Flamme eine Ionisationssonde ist, die das Vorhandensein positiver Ionen ausnutzt, die durch die Verbrennung von Wasserstoff und Sauerstoff entwickelt werden, um einen elektrischen Strom zu erzeugen, wobei die Verarbeitungseinheit so programmiert ist, dass sie auf der Grundlage der Messung des genannten Stroms feststellt, ob die Flamme der Brennkammer gezündet ist oder nicht, und dass sie auf dieser Grundlage eine Schätzung der C02-Produktion vornimmt, wobei die Verarbeitungseinheit auch so programmiert ist, dass sie auf der Grundlage der C02-Schätzung die Parameter der Ansauggeschwindigkeit und/oder der in die Brennkammer eingeführten Luftmenge einstellt.

11. Thermoelektrischer Generator nach Anspruch 9 oder 10, **dadurch gekennzeichnet, dass** die Sonde für die Anwesenheit der Flamme aus zwei Elektroden besteht, die von der Flamme durchquert werden, einer positiven und einer negativen, wobei die durch die Wärme der Flamme erzeugten Ionen von der negativen, elektronenreichen Elektrode angezogen werden und einen schwachen Gleichstrom erzeugen, der von der Verarbeitungseinheit gemessen wird.

12. Thermoelektrischer Generator nach einem der vorstehenden Ansprüche, **dadurch gekennzeichnet, dass** die Seebeck-Effekt-Zellen jeweils Teil einer entsprechenden gekühlten Seebeck-Einheit sind, wobei jede gekühlte Seebeck-Einheit eine Druckplatte (58) zum Festklemmen einer Seebeck-Zelle (55) an einer relativ nach oben konvergierenden Wand (25a, 25b) der Brennkammer (25) umfasst, wobei die Platte mindestens einen teilweisen Stützsitz (62) eines Kühlkreislaufs (30) auf einer Seite (58b) gegenüber einer anderen Seite (58a) des Kontakts mit der Seebeck-Zelle (55) definiert.

13. Thermoelektrischer Generator nach dem vorstehenden Anspruch, **dadurch gekennzeichnet, dass** jede gekühlte Seebeck-Einheit eine zweite Platte (60) umfasst, die mit der Kompressionsplatte (58) verbunden ist, um zwischen ihnen einen Aufnahme- und Stützsitz (62) eines Kanals (65) des Kühlkreislaufs (30) zu definieren.

14. Verfahren zur Steuerung der Verbrennung in einem Generator nach einem der vorstehenden Ansprüche, umfassend:
Versorgen der Brennkammer mit Luft und Brenngas ohne diese miteinander vorzumischen;
Einführen der nicht mit dem Gas vorgemischten Luft in die Brennkammer durch Ansaugen in einer variablen Menge, die auf der Grundlage von mindestens einem der folgenden Parameter definiert wird: einem Parameter der Abgase, einem Parameter der Flamme in der Verbrennungskammer, der Höhe über dem Meeresspiegel, dem atmosphärischen Druck, einem Wert des Stroms.

15. Verfahren nach Anspruch 14, wobei der Flammenparameter ein Gleichstrom ist, der mittels einer Ionisationssonde bestimmt wird.

## Revendications

1. Générateur thermoélectrique comprenant une chambre de combustion (25) qui loge intérieurement des moyens de protection et de rayonnement (45) pour protéger au moins une paroi de la chambre de combustion contre la chaleur directe provenant de la flamme de combustion, sur le côté extérieur de l'au moins une paroi une pluralité de moyens de génération pour la génération d'énergie électrique par effet Seebeck (55, 70) sont fixés, et pour rayonner vers l'au moins une paroi une chaleur sensiblement uniformément répartie, où ladite pluralité de moyens de génération comprend une pluralité de cellules à effet Seebeck fixées à ladite paroi, les unes indépendamment des autres, et agencées de façon à recouvrir l'au moins une paroi au moins partiellement avec un motif de carreaux de mosaïque ;
le générateur thermoélectrique étant **caractérisé par le fait que** ladite chambre de combustion est une chambre de combustion sensiblement prismatique (25) ayant une section sensiblement triangulaire :
• la chambre de combustion prismatique comprend deux parois convergeant vers le haut (25a et 25b), au moins l'une étant recouverte extérieurement à la chambre de combustion par des moyens pour la génération d'énergie électrique par effet Seebeck (55, 70) ;
• la chambre de combustion loge intérieurement des moyens de génération de flamme (36) à proximité ou au niveau du côté inférieur du prisme ;
• la chambre de combustion loge intérieurement des moyens de protection et de rayonnement (45) pour protéger lesdites parois convergeant vers le haut (25a, 25b) contre la chaleur directe provenant de ladite flamme et pour rayonner vers elles une chaleur sensiblement uniformément répartie.

2. Générateur thermoélectrique selon la revendication 1, **caractérisé en ce que** ledit côté extérieur est sensiblement plan et lesdites cellules à effet Seebeck possèdent une paroi plane correspondante de contact avec celui-ci, où les cellules à effet Seebeck sont placées côte à côte les unes des autres avec un motif de carreaux de mosaïque de façon à recouvrir uniformément au moins partiellement ledit côté extérieur, plus préférablement lesdites deux parois convergeant vers le haut (25a et 25b).

3. Générateur thermoélectrique selon la revendication 1 ou 2, **caractérisé en ce que** les moyens de protection et de rayonnement (45) comprennent une bride ayant une section en forme de V, interposée entre les moyens de génération de flamme et lesdites parois convergeant vers le haut de la chambre de combustion, orientée avec la cuspide (46) comme la cuspide (38) formée par lesdites parois convergeant vers le haut (25a, 25b) .

4. Générateur thermoélectrique selon la revendication précédente, **caractérisé en ce que** la bride (45) s'étend sensiblement sur la totalité de la longueur L de la chambre de combustion (25) dans une direction orthogonale à la section triangulaire, où de préférence également les moyens de génération de flamme (36) possèdent la même longueur.

5. Générateur thermoélectrique selon la revendication 3 ou 4, **caractérisé en ce que** la bride (45) comprend une ou plusieurs ouvertures (48) sur les deux côtés de la bride ayant une section en forme de V agencée dans les zones ayant une chaleur moindre, en particulier dans une position proximale à la cuspide (46), pour permettre un plus grand passage de la chaleur de la flamme aux parties supérieures des parois convergeant vers le haut (25a et 25b) de la chambre de combustion.

6. Générateur thermoélectrique selon l'une quelconque des revendications précédentes dans lequel la chambre de combustion (25) est alimentée séparément en air et en gaz combustible d'une manière telle qu'ils soient introduits sous une forme non prémélangée entre eux et dans un rapport variable, en particulier la chambre de combustion est alimentée par des moyens d'alimentation en air (82) et des moyens d'alimentation en gaz combustible (84) respectifs, où :
• le générateur comprend des moyens (72) pour l'aspiration forcée des gaz de carneau ;
• les moyens d'alimentation en air (82) comprennent une ouverture d'aspiration de dimensions variables au moyen d'un papillon (82).

7. Générateur thermoélectrique selon la revendication précédente, **caractérisé en ce que** le papillon (82) est commandé ou réglé manuellement, sur la base des indications données par une unité de traitement (78) communiquant avec au moins une sonde pour la détection d'au moins un paramètre des gaz de carneau (74) de la chambre de combustion et au moins avec des moyens pour la détection de l'altitude (76) et/ou avec des moyens pour la détection de la pression atmosphérique.

8. Générateur thermoélectrique selon la revendication précédente, **caractérisé en ce que** l'unité de traitement (78) est programmée selon des fenêtres opérationnelles optimales, chacune identifiée par une combinaison de plages de valeurs de paramètres sélectionnés parmi un paramètre des gaz de carneau, un paramètre de la flamme dans la chambre de combustion, l'altitude, la pression atmosphérique, une valeur de courant, en particulier l'unité de traitement est programmée pour associer une position prédéterminée respective du papillon d'air d'admission à chaque fenêtre opérationnelle optimale.

9. Générateur thermoélectrique selon l'une quelconque des revendications 6 à 8, **caractérisé en ce que** le papillon (82) est commandé ou réglé manuellement, sur la base des indications données par une unité de traitement (78) communiquant avec au moins une sonde pour la détection de la présence d'une flamme dans la chambre de combustion (25).

10. Générateur thermoélectrique selon la revendication précédente, **caractérisé en ce que** la sonde de présence de flamme est une sonde d'ionisation qui exploite la présence d'ions positifs développés par la combustion d'hydrogène et d'oxygène pour générer un courant électrique, l'unité de traitement étant programmée pour déterminer si la flamme de la chambre de combustion est allumée ou non sur la base de la mesure dudit courant et pour effectuer une estimation de la production de CO2 sur la base de celle-ci, l'unité de traitement est également programmée pour ajuster les paramètres de la vitesse d'aspiration et/ou de la quantité d'air introduite dans la chambre de combustion sur la base de ladite estimation de CO2.

11. Générateur thermoélectrique selon la revendication 9 ou 10, **caractérisé en ce que** la sonde de présence de flamme est composée de deux électrodes traversées par la flamme, l'une positive et l'autre négative, les ions produits par la chaleur de la flamme sont attirés vers l'électrode négative riche en électrons et donnent naissance à un faible courant continu mesuré par l'unité de traitement.

12. Générateur thermoélectrique selon l'une quelconque des revendications précédentes **caractérisé en ce que** lesdites cellules à effet Seebeck font chacune partie d'une unité Seebeck refroidie respective, dans lequel chaque unité Seebeck refroidie comprend une plaque de compression (58) pour la fixation d'une cellule de Seebeck (55) sur une paroi convergeant vers le haut (25a, 25b) apparentée de la chambre de combustion (25), où ladite plaque définit au moins un siège de support partiel (62) d'un circuit de refroidissement (30) sur un côté (58b) opposé à un autre côté (58a) de contact avec la cellule de Seebeck (55).

13. Générateur thermoélectrique selon la revendication précédente, **caractérisé en ce que** chaque unité Seebeck refroidie comprend une seconde plaque (60) couplée à la plaque de compression (58) pour définir entre elles un siège de logement et de support (62) d'un conduit (65) du circuit de refroidissement (30).

14. Procédé pour la commande de la combustion dans un générateur selon l'une quelconque des revendications précédentes, comprenant :
- l'alimentation de la chambre de combustion en air et en gaz combustible non prémélangés entre eux ;
- l'introduction dans la chambre de combustion, par aspiration, de l'air non prémélangé avec le gaz et dans une quantité variable définie sur la base d'au moins l'un parmi : un paramètre des gaz de carneau, un paramètre de la flamme dans la chambre de combustion, l'altitude, la pression atmosphérique, une valeur de courant.

15. Procédé selon la revendication 14, dans lequel le paramètre de flamme est un courant continu déterminé au moyen d'une sonde d'ionisation.
